# FASCICULE DE BREVET EUROPEEN

(11) **EP 1 985 164 B1**
(45) Date de publication et mention de la délivrance du brevet: **11.06.2014**
(21) Numéro de dépôt: 07730981.3
(22) Date de dépôt: 15.02.2007
(51) Int. Cl.: H05K 3/34, H05K 13/04

(54) **PROCEDE DE FABRICATION D'UN MODULE ELECTRONIQUE PAR FIXATION SEQUENTIELLE DES COMPOSANTS.**
VERFAHREN ZUM HERSTELLEN VON ELEKTRONISCHEN MODULEN DURCH AUFEINANDERFOLGENDE BEFESTIGUNG DER BAUELEMENTEN
METHOD FOR PRODUCING AN ELECTRONIC MODULE BY SEQUENTIAL FIXATION OF THE COMPONENTS

(30) Priorité: 16.02.2006 FR 0601356
(43) Date de publication de la demande: 29.10.2008
(60) Demande divisionnaire: 14165661.1
(73) Titulaire: Valeo Systèmes de Contrôle Moteur, 95800 Cergy (FR)
(72) Inventeur: LEFEVRE, Bruno, F-91210 Draveil (FR); MORENO, Jean-Yves, F-60110 Meru (FR); SCHWARTZ, Christian, F-78400 Chatou (FR)
(74) Mandataire: Rolland, Jean-Christophe
(86) Numéro de dépôt international: PCT/FR2007/000270
(87) Numéro de publication internationale: WO 2007/093709

(56) Documents cités:
- DE-C1- 4 330 467
- JP-A- 7 312 412
- US-A- 3 558 993
- US-A- 5 394 608

## Description

La présente invention concerne un procédé de fabrication d'un module électronique utilisable par exemple dans le domaine automobile, et une ligne de production correspondante.

### ARRIERE PLAN DE L'INVENTION

Un module électronique comporte généralement une carte à circuit imprimé sur laquelle sont brasés des composants électroniques.

Les procédés actuels de fabrication comportent les étapes de disposer de la brasure sur la carte, généralement sous la forme d'une pâte, de positionner les composants sur celle-ci et de fondre la brasure en faisant passer la carte dans un four à refusion. Cette étape de fusion de la brasure est couramment appelée soudage des composants. La présence de composants d'encombrement important sur la carte ou de concentrations de composants dans certaines zones de la carte entraînent des gradients de température dans la carte, c'est-à-dire que les différentes zones de la carte n'atteignent pas la température de consigne du four de refusion en même temps. Ces gradients de température engendrent des contraintes thermiques tant sur la carte que sur les composants ayant subi le chauffage le plus important. Les contraintes thermiques peuvent entraîner une dégradation des performances et un vieillissement prématuré des composants. Pour éviter ou limiter ces gradients de température, il est nécessaire d'élaborer, en fonction de chaque type de modules, des profils thermiques spécifiques du four de refusion qui s'avèrent délicats à maîtriser.

Les composants les plus encombrants limitent également les échanges thermiques qui assureraient une fusion optimale de la brasure en masquant les composants les plus petits ou des parties de ceux-ci.

En outre, ces composants d'encombrement plus important masquent d'autres composants et empêchent un contrôle visuel de ces composants masqués.

Par ailleurs, avec les procédés connus utilisant un four de refusion, le passage dans le four de refusion limite la hauteur maximale que peuvent avoir les composants.

De plus, l'apparition de nouvelles normes portant sur la composition de la brasure risquent d'entraîner une élévation de la température de fusion de la brasure. Cette élévation de température risque d'augmenter les contraintes thermiques subies par les composants. Il sera alors nécessaire d'utiliser pour la réalisation des corps des composants des matériaux plastiques techniques améliorés pour supporter sans dommage cette température. Certains composants dont les performances peuvent être affectées par un excès de chaleur devront également être améliorés.

### OBJET DE L'INVENTION

Un but de l'invention est de fournir un moyen permettant de limiter les contraintes thermiques lors de la fabrication d'un module électronique.

### RESUME DE L'INVENTION

A cet effet, on prévoit, selon l'invention, un procédé de fabrication d'un module électronique comme décrit dans la revendication 1.

Ainsi, le soudage du composant du premier type est réalisé avant que le composant du deuxième type ne soit mis en place. Le composant du deuxième type ne gêne donc pas le soudage du composant du premier type ni les opérations de contrôle de la qualité de ce soudage. On positionnera alors par exemple les composants encombrants après la première étape de soudure. Le composant de deuxième type peut protéger le composant de premier type, notamment en formant un écran vis-à-vis du composant du deuxième type. Ceci est particulièrement intéressant lorsque le composant du deuxième type a un encombrement supérieur à l'encombrement du composant du premier type. Il est en outre possible d'éviter les concentrations de composants en répartissant le soudage des composants proches sur les deux opérations de soudage.

Selon l'invention, le soudage du composant du deuxième type est réalisé en appliquant deux électrodes sur chaque patte du composant et en faisant circuler un courant électrique entre les électrodes pour chauffer chaque patte du composant.

Avec ce mode de soudage, seules les pattes du composant sont échauffées, de sorte que le composant lui-même et les composants environnants ne subissent que peu ou pas d'élévation de température. Il est donc possible d'utiliser des composants présentant des propriétés de résistance à la température relativement moyennes.

L'invention a également pour objet une ligne de production pour la mise en oeuvre de ce procédé. La ligne de production comprend une unité de mise en place des composants du premier type, une première unité de chauffage pour faire fondre une brasure disposée entre les composants du premier type et le circuit, une unité de mise en place des composants du deuxième type et une deuxième unité de chauffage pour faire fondre une brasure disposée entre les composants du deuxième type et le circuit.

D'autres caractéristiques et avantages de l'invention ressortiront à la lecture de la description qui suit d'un mode de réalisation particulier non limitatif de l'invention.

### BREVE DESCRIPTION DES DESSINS

Il sera fait référence aux dessins annexés, parmi lesquels :
- la figure 1 est une vue schématique d'une ligne de fabrication de modules électroniques selon l'invention,
- la figure 2 est une vue schématique partielle en perspective d'un tel module lors du soudage d'un composant,
- la figure 3 est une vue analogue à celle de la figure 2 de ce module après le soudage du composant.

### DESCRIPTION DETAILLEE DE L'INVENTION

En référence aux figures, le procédé de fabrication conforme à l'invention est mis en oeuvre sur une ligne de production, généralement désignée en 1, pour fabriquer des modules électroniques généralement désignés en 2.

Un module électronique 2 comprend une carte 3 sur laquelle a été formé un circuit 4 conducteur pour constituer de façon connue en soi une carte à circuit imprimé. La carte 3 est de type SMI (substrat métallique isolé). Le circuit 4 peut être formé d'une encre conductrice étendue par sérigraphie sur la carte 3. Le circuit peut également être constitué de pistes métalliques fixées sur la carte 3.

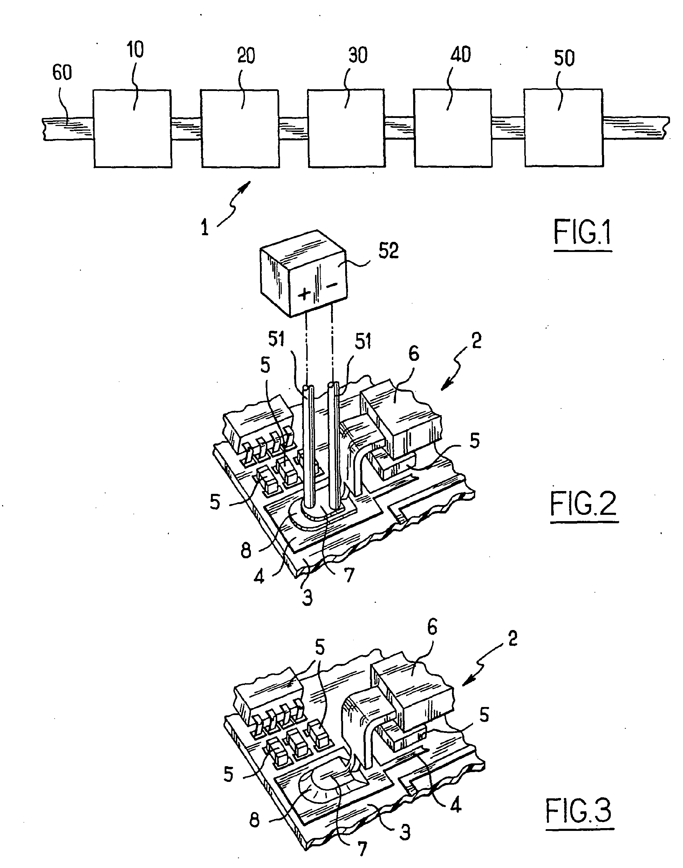

Le module 2 comprend également des composants d'un premier type 5 et un composant d'un deuxième type 6 comportant des pattes de connexion 7 dont une seule est représentée sur les figures 2 et 3. Les composants 5, tels que des composants de commande, sont de plus petite taille que le composant 6 qui est par exemple un composant de puissance. Le composant 6 s'étend ici au-dessus d'un des composants 5. Les pattes de connexion, ou plus généralement les organes de connexion, des composants 5 et 6 sont fixés sur le circuit 4 par de la brasure 8 fondue. La brasure 8 est ici de la pâte à braser constituée d'un mélange d'étain et de plomb.

La ligne de production 1 comprend une unité 10 de dépôt de la brasure 8 sur le circuit 4 des cartes 3, une unité 20 de mise en place des composants 5, une unité de chauffage 30 constitué ici d'un four de refusion, une unité 40 de mise en place des composants 6 et une unité de soudage 50 des composants 6.

Les unités 10, 20, 30 et 40 sont connues en elles-mêmes.

L'unité de soudage 50 comprend des paires d'électrodes 51 reliées à une source d'énergie électrique 52 délivrant ici un courant de l'ordre de 3000 ampères à une fréquence minimum de 1000 hertz. Les électrodes sont ici réalisées en cuprotungstène (25 % de cuivre et 75 % de tungstène)

Les différentes unités sont reliées entre elles de façon classique par un convoyeur 60 transportant les cartes 3.

Le circuit 4 est déjà imprimé sur les cartes 3 lorsque celles-ci arrivent dans la ligne de production 1.

Dans l'unité 10, la brasure 8 est déposée par sérigraphie sur les plages de connexion du circuit 4 aux composants 5 et 6.

Les composants 5 sont ensuite placés par l'unité 20 sur le circuit 4 de manière que les organes de connexion des composants 5 reposent sur la brasure 8 déposée sur les plages de connexion correspondantes du circuit 3.

La carte 3 ainsi équipée des composants 5 passe dans l'unité de chauffage 30 qui fait fondre la brasure 8 et permet le soudage des composants 5.

Il est possible de procéder à un contrôle visuel du soudage des composants 5 à la sortie du four de refusion 30. Le composant 6 n'étant pas sur la carte lors du passage dans le four à refusion 30, la masse à chauffer durant ce passage est relativement faible, ce qui permet d'utiliser des fours de plus faible capacité ou de faire passer simultanément dans le four plus de cartes.

La carte 3 passe ensuite dans l'unité 40 dans laquelle le composant 6 est positionné sur le circuit 4 de manière que les pattes 7 du composant 6 reposent sur la brasure 8 déposée sur les plages de connexion correspondantes du circuit 3.

Il est alors procédé au soudage des composants 6 en appliquant sur chaque patte 7 des composants 6 une paire d'électrodes 51 pour faire circuler un courant électrique entre lesdites électrodes via la patte 7 correspondante et chauffer chaque patte 7 du composant 6 de façon suffisante pour faire fondre la brasure 8. On notera que la pression des électrodes sur la pièce à braser garantit un bon plaquage de la pièce à braser sur le circuit. A titre d'exemple, les électrodes peuvent exercer un effort de 12 daN sur la pièce à braser.

La fusion de la brasure au moyen des électrodes a l'avantage d'être extrêmement rapide (moins d'une seconde) alors qu'un passage dans un four de refusion dure environ une minute.

Il est possible d'influer sur la qualité de la brasure ou d'adapter le soudage aux matériaux ou aux composants à souder en modifiant le profil de brasage (et notamment la courbe d'intensité du courant en fonction du temps, la pression mécanique des électrodes sur les pattes des composants), la géométrie des électrodes (afin notamment de permettre une meilleure évacuation des calories), l'effort exercé sur la pièce (afin de maintenir le contact entre l'électrode et la pièce et éviter la formation d'une étincelle), l'écartement et le positionnement des électrodes sur les pattes (notamment pour modifier le cheminement du courant dans les pattes). La température des électrodes est maintenue sensiblement constante et relativement basse, de l'ordre de 40°C, afin de conserver les mêmes conditions de soudage pour toutes les pièces, d'où l'intérêt de prévoir des moyens pour faciliter l'évacuation des calories au niveau des électrodes, comme une géométrie adaptée.

Bien entendu, l'invention n'est pas limitée au mode de réalisation décrit et on peut y apporter des variantes de réalisation sans sortir du cadre de l'invention tel que défini par les revendications.

En particulier, il est possible de déposer la brasure utilisée pour le soudage des composants 6 après le soudage des composants 5 par une opération d'impression par sérigraphie. La brasure peut également être déposée directement sur les pattes des composants avant leur mise en place sur le circuit.

Il est possible de chauffer la pâte des composants de façon différente, par exemple en appliquant une panne chauffante sur chaque patte des composants 6 ou des composants 5. L'unité de chauffage 50 peut être un four de refusion.

Les électrodes peuvent être réalisées à partir de différents métaux, notamment à partir de cuivre, de tungstène, de molybdène... Les électrodes peuvent ainsi être réalisées en cuprotungstène (25 % de cuivre et 75 % de tungstène) comme dans le mode de réalisation décrit ou être réalisées en cuivre et comprendre une pastille d'extrémité en tungstène pour servir de point de contact avec la pièce à braser.

Les pièces à braser peuvent être en cuivre, en laiton, en un alliage ou en un métal étamé ou non... La carte peut être de type SMI comme décrit ou être d'un autre type et par exemple comprendre un circuit à trame de verre et résine époxy comme les cartes de type FR4.

Il est possible d'utiliser d'autres brasures, à base d'étain, à base d'argent, sans plomb... La brasure peut également être déposée sous forme d'une bande métallique soit sur le circuit soit sur les organes de connexion des composants.

Les modules peuvent bien entendu avoir une structure différentes de celle du mode de réalisation ci-dessus qui n'a été précisée que pour expliquer l'invention et n'est absolument pas limitative. Les composants 6 mis en place après le passage des cartes dans le four de refusion 30 peuvent être des composants encombrants ou des composants qui pourraient être détériorés par la chaleur régnant dans le four. Les composants 6 peuvent être identiques aux composants 5 mais soudés ultérieurement pour éviter les concentrations de composants trop importantes lors du premier soudage.

## Revendications

1. Procédé de fabrication d'un module électronique (2) comportant une carte (3) à circuit imprimé (4), au moins un composant d'un premier type (5) et un composant d'un deuxième type (6), ou le procédé comprend les étapes de :
- disposer de la brasure (8) sur la carte,
- positionner le composant du premier type,
- fondre la brasure pour souder le composant du premier type,
- positionner le composant du deuxième type de telle manière que celui-ci s'étende au-dessus du composant du premier type et ait des pattes (7) en appui sur la carte par de la brasure,
- fondre la brasure pour souder le composant du deuxième type, **caractérisé en ce que**
dans ledit procédé, le soudage du composant du deuxième type (6) est réalisé en appliquant deux électrodes (51) sur chaque patte (7) du composant et en faisant circuler un courant électrique entre les électrodes pour chauffer chaque patte du composant.

2. Procédé selon la revendication 1, dans lequel le soudage du composant du premier type (5) est réalisé par passage de la carte dans un four de refusion (30).

3. Procédé selon la revendication 1, dans lequel une phase d'adaptation du soudage au composant du deuxième type est réalisée en modifiant un ou plusieurs des paramètres suivants :
- un profil de brasage,
- une courbe d'intensité de courant des électrodes (51),
- une pression mécanique des électrodes sur les pattes (7) du composant du deuxième type (6),
- une géométrie des électrodes,
- un écartement et un positionnement des électrodes sur les pattes du composant.

4. Procédé selon la revendication 1, dans lequel la brasure (8) utilisée pour le soudage du composant du deuxième type (6) est disposée sur le circuit (4) de la carte (2) en même temps que la brasure utilisée pour la soudure du composant du premier type (5).

5. Procédé selon la revendication 4, dans lequel la brasure (8) est une pâte à braser.

6. Procédé selon la revendication 1, dans lequel la brasure (8) est déposée sur les pattes (7) du composant du deuxième type (6) préalablement à son positionnement.

7. Procédé selon la revendication 1, dans lequel le composant du deuxième type (6) s'étend au-dessus du composant du premier type (5).

## Patentansprüche

1. Verfahren zur Herstellung eines Elektronikmoduls (2), das eine Karte (3) mit gedruckter Schaltung (4), mindestens ein Bauelement von einem ersten Typ (5) und ein Bauelement von einem zweiten Typ (6) aufweist, wobei das Verfahren die folgenden Schritte aufweist:
- Anordnen von Lot (8) auf der Karte,
- Positionieren des Bauelements des ersten Typs,
- Schmelzen des Lots zum Löten des Bauelements des ersten Typs,
- Positionieren des Bauelements des zweiten Typs derart, dass dieses sich über dem Bauelement des ersten Typs erstreckt und Lappen (7) aufweist, die über das Lot auf der Karte aufliegen,
- Schmelzen des Lots zum Löten des Bauelements des zweiten Typs, **dadurch gekennzeichnet, dass**
in diesem Verfahren das Löten des Bauelements des zweiten Typs (6) ausgeführt wird, indem zwei Elektroden (51) auf jedem Lappen (7) des Bauelements angebracht werden und indem ein elektrischer Strom zwischen den Elektroden zum Fließen gebracht wird, um jeden Lappen des Bauelements zu erwärmen.

2. Verfahren nach Anspruch 1, wobei das Löten des Bauelements des ersten Typs (5) durch Durchlauf der Karte durch einen Umschmelzofen (30) ausgeführt wird.

3. Verfahren nach Anspruch 1, wobei eine Phase der Anpassung der Lötung an das Bauelement des zweiten Typs durch Ändern von einem oder mehreren der folgenden Parameter ausgeführt wird:
- eines Lötprofils,
- einer Stromstärkekurve der Elektroden (51),
- eines mechanischen Drucks der Elektroden auf die Lappen (7) des Bauelements des zweiten Typs (6),
- einer Geometrie der Elektroden,
- eines Abstands und einer Positionierung der Elektroden auf den Lappen des Bauelements.

4. Verfahren nach Anspruch 1, wobei das Lot (8), das zum Löten des Bauelements des zweiten Typs (6) verwendet wird, zum selben Zeitpunkt auf der Schaltung (4) der Karte (2) angeordnet wird wie das Lot, das zum Löten des Bauelements des ersten Typs (5) verwendet wird.

5. Verfahren nach Anspruch 4, wobei das Lot (8) eine Lötpaste ist.

6. Verfahren nach Anspruch 1, wobei das Lot (8) auf den Lappen (7) des Bauelements des zweiten Typs (6) vor dessen Positionierung aufgetragen wird.

7. Verfahren nach Anspruch 1, wobei das Bauelement des zweiten Typs (6) sich über dem Bauelement des ersten Typs (5) erstreckt.

## Claims

1. Method for producing an electronic module (2) comprising a board (3) with a printed circuit (4), at least one component of a first type (5) and a component of a second type (6), the method comprisinge steps of:
- placing solder (8) on the board,
- positioning the component of the first type,
- melting the solder in order to solder the component of the first type,
- positioning the component of the second type such that the latter extends above the component of the first type and has pads (7) supported on the board by the solder,
- melting the solder to solder the component of the second type,
**characterized in that** wherein, in said method, the component of the second type (6) is soldered by applying two electrodes (51) to each pad (7) of the component and by running an electrical current between the electrodes to heat each pad of the component.

2. Method according to Claim 1, wherein the component of the first type (5) is soldered by running the board in a reflow oven (30).

3. Method according to Claim 1, wherein a phase of adapting the solder to the component of the second type is carried out by modifying one or more of the following parameters:
- a solder profile,
- a current intensity curve of the electrodes (51),
- the mechanical pressure of the electrodes on the pads (7) of the component of the second type (6),
- the geometry of the electrodes,
- the spacing and positioning of the electrodes on the pads of the component.

4. Method according to Claim 1, wherein the solder (8) used for soldering the component of the second type (6) is placed on the circuit (4) of the board (2) at the same time as the solder used for soldering the component of the first type (5).

5. Method according to Claim 4, wherein the solder (8) is a solder paste.

6. Method according to Claim 1, wherein the solder (8) is placed on the pads (7) of the component of the second type (6) before it is positioned.

7. Method according to Claim 1, wherein the component of the second type (6) extends above the component of the first type (5).
